# EUROPEAN PATENT APPLICATION

(11) **EP 4 576 488 A1**
(43) Date of publication of application: **25.06.2025**
(21) Application number: 23855037.0
(22) Date of filing: 04.07.2023
(51) Int. Cl.: H02J 7/00, G06N 20/00

(54) **CHARGING TIME ESTIMATION DEVICE AND METHOD FOR OPERATING SAME**

(30) Priority: 17.08.2022 KR 20220103001
(71) Applicant: LG Energy Solution, Ltd., Seoul 07335 (KR)
(72) Inventor: EOM, Jin Uk, Daejeon 34122 (KR); YOO, Ji Won, Daejeon 34122 (KR); BAEK, Jong Shik, Daejeon 34122 (KR); CHOI, Yo Hwan, Daejeon 34122 (KR); KIM, Joo Sung, Daejeon 34122 (KR)
(74) Representative: Goddar, Heinz J.
(86) International application number: PCT/KR2023/009444
(87) International publication number: WO 2024/039066

(57) **Abstract**

A charging time prediction apparatus according to an embodiment disclosed herein includes a communication circuit and a processor, in which the processor is configured to receive, from an external electronic device through the communication circuit, first battery information comprising a current value, a temperature value, a state of charge (SoC), and a state of health (SoH) during a designated time period of a battery included in the external electronic device, receive, through the communication circuit, information about a driving speed of the external electronic device and/or information about whether the external electronic device is connected to an external charger for the designated time period, extract a charging period from the designated time period based on the first battery information, the information about the driving speed, and/or the information about the connection for the designated time period, and generate a charging time prediction model by using a current value, a temperature value, an SoC, and an SoH at a first time point of the charging period and an SoC at a second time point of the charging period.

## Description

### [TECHNICAL FIELD]

### CROSS-REFERENCE TO RELATED APPLICATION

This application claims priority to and the benefit of Korean Patent Application No. 10-2022-0103001 filed in the Korean Intellectual Property Office on August 17, 2022, the entire contents of which are incorporated herein by reference.

### TECHNICAL FIELD

Embodiments disclosed herein relate to a charging time prediction apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight. The lithium-ion battery has been used as a power source of mobile devices and, recently, a use range thereof has been extended to power sources for electric vehicles, attracting attention as next-generation energy storage media.

A user determines whether to continue charging a battery up to a target state of charge (SoC) from a required charging time. Therefore, it is important to accurately provide the required charging time to the user.

Conventionally, to predict the required charging time, a method of calculating a required charging time matching the current temperature and SoC of the battery based on a preset table has been used.

### [DISCLOSURE]

### [TECHNICAL PROBLEM]

However, a conventional charging time prediction scheme has a limitation of an error between a calculated required charging time and an actual required charging time because of a limited data capacity of a preset table and no consideration of a deterioration rate of the battery.

Embodiments disclosed herein aim to provide a charging time prediction apparatus and an operating method thereof, in which a required charging time may be predicted while minimizing an error from an actual required charging time.

Technical problems of the embodiments disclosed herein are not limited to the above-described technical problems, and other unmentioned technical problems would be clearly understood by one of ordinary skill in the art from the following description.

### [TECHNICAL SOLUTION]

A charging time prediction apparatus according to an embodiment disclosed herein includes a communication circuit and a processor, in which the processor is configured to receive, from an external electronic device and through the communication circuit, first battery information including a current value, a temperature value, a state of charge (SoC), and an state of health (SoH) during a designated time period of a battery included in the external electronic device, receive, through the communication circuit, information about a driving speed of the external electronic device and/or information about whether the external electronic device is connected to an external charger for the designated time period, extract a charging period from the designated time period based on the first battery information, the information about the driving speed, and/or the information about the connection for the designated time period, and generate a charging time prediction model by using a current value, a temperature value, an SoC, and an SoH at a first time point of the charging period and an SoC at a second time point of the charging period.

According to an embodiment disclosed herein, the processor may be further configured to receive, from the external electronic device and through the communication circuit, second battery information including a current value, a temperature value, an SoC, and an SoH of the battery at a designated time point, and predict a required charging time from the SoC to a target SoC at the designated time point based on the charging time prediction model.

According to an embodiment disclosed herein, the first battery information may include model information of the battery, and the processor may be further configured to generate the charging time prediction model corresponding to the model information.

According to an embodiment disclosed herein, the processor may be further configured to extract, as the charging period and from the designated time period, at least a part of a first period in which the current value of the battery is greater than or equal to a designated current value.

According to an embodiment disclosed herein, the processor may be further configured to extract, as the charging period and from the first period, at least a part of a second period in which the driving speed of the external electronic device is a designated speed and the external electronic device is connected to the external charger.

According to an embodiment disclosed herein, the processor may be further configured to extract, as the charging period and from the second period, at least a part of a third period by excluding a data disconnection period, a period in which a charging time is less than a designated time, and a period in which a charging amount is less than a designated charging amount.

According to an embodiment disclosed herein, the processor may be further configured to extract, as the charging period and from the third period, a period by excluding a period in which a current change value of the battery is greater than or equal to a designated change value.

According to an embodiment disclosed herein, the processor may be further configured to transmit a required charging time to the external electronic device through the communication circuit to provide a predicted required charging time to a user.

A charging time prediction method according to an embodiment disclosed herein includes obtaining first battery information including a current value, a temperature value, a state of charge (SoC), and a state of health (SoH) of a battery included in an external electronic device for a designated time period, obtaining information about a driving speed of the external electronic device and/or information about whether the external electronic device is connected to an external charger, extracting a charging period from the designated time period based on the first battery information, the information about the driving speed, and/or the information about the connection for the designated time period, and generating a charging time prediction model by using a current value, a temperature value, an SoC, and an SoH at a first time point of the charging period and an SoC at a second time point of the charging period.

According to an embodiment disclosed herein, the first battery information may include model information of the battery, and generating the charging time prediction model may include generating the charging time prediction model corresponding to the model information.

According to an embodiment disclosed herein, extracting the charging period may include extracting, as the charging period and from the designated time period, at least a part of a first period in which the current value of the battery is greater than or equal to a designated current value.

According to an embodiment, extracting the charging period may include extracting, as the charging period and from the first period, at least a part of a second period in which a driving speed of the external electronic device is a designated speed and the external electronic device is connected to the external charger.

According to an embodiment disclosed herein, extracting the charging period may include extracting, as the charging period and from the second period, at least a part of a third period by excluding a data disconnection period, a period in which the charging time is less than a designated time, and a period in which a charging amount is less than a designated charging amount.

According to an embodiment disclosed herein, extracting the charging period may include extracting, as the charging period and from the third period, a period by excluding a period in which a current change value of the battery is greater than or equal to a designated change value.

### [ADVANTAGEOUS EFFECTS]

According to embodiments disclosed herein, a required charging time may be predicted based on a charging time prediction model generated and/or trained using battery information including a current value, a temperature value, an SoC, and an SoH of a battery, thereby improving the accuracy of prediction of the required charging time.

According to embodiments disclosed herein, by extracting information of a charging period from the battery information, the accuracy of prediction of the required charging time by the charging time prediction model may be further enhanced.

According to embodiments disclosed herein, the predicted required charging time may be provided to a user, thereby improving user convenience.

Moreover, various effects recognized directly or indirectly from the disclosure may be provided.

### [DESCRIPTION OF DRAWINGS]

FIG. 1 is a block diagram showing a charging time prediction apparatus according to an embodiment disclosed herein.
FIG. 2 is an operating flowchart of a charging time prediction apparatus according to an embodiment disclosed herein.
FIG. 3 is an operating flowchart of a charging time prediction apparatus according to an embodiment disclosed herein.
FIG. 4 is an operating flowchart of a charging time prediction apparatus according to an embodiment disclosed herein.
FIG. 5 is a view showing an interface provided by a charging time prediction apparatus to a user, according to an embodiment disclosed herein.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspects (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wired), wirelessly, or via a third element.

According to an embodiment of the disclosure, a method according to various embodiments of the disclosure herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively, or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

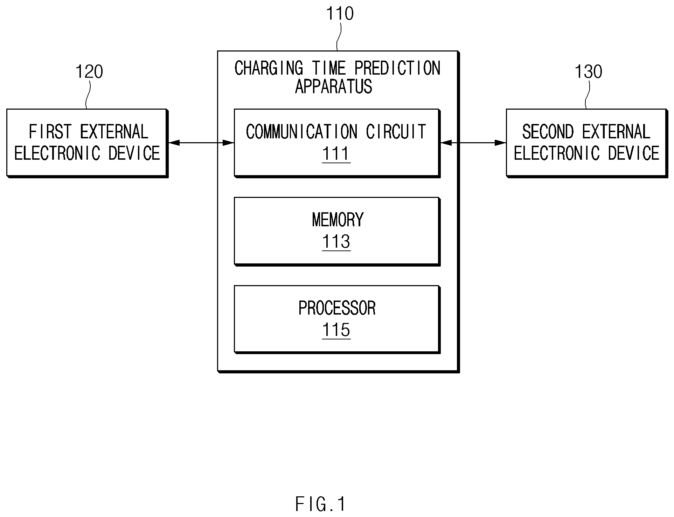

FIG. 1 is a block diagram showing a charging time prediction apparatus according to an embodiment disclosed herein.

Referring to FIG. 1, a charging time prediction apparatus 110 may include a communication circuit 111, a memory 113, and/or a processor 115. According to some embodiments, in the charging time prediction apparatus 110, at least one of the components illustrated in FIG. 1 may be omitted or one or more other components may be added. In some embodiments, some of these components may be implemented as a single integrated circuit.

The communication circuit 111 may, wirelessly or wired, transmit and receive data to and from a first external electronic device 120 and/or a second external electronic device 130. Herein, the first external electronic device 120 may be an electric vehicle using electric energy, and the second external electronic device 130 may be a portable electronic device such as a smart phone or a tablet personal computer (PC).

According to an embodiment, the communication circuit 111 may receive information about a battery included in the first external electronic device 120 from the first external electronic device 120. Herein, the information about the battery may include model information, current value, temperature value, SoC, and/or SoH of the battery included in the first external electronic device 120. The communication circuit 111 may receive a target SoC that is set based on a user input from the first external electronic device 120 or the second external electronic device 130. According to an embodiment, the communication circuit 111 may transmit the information received from the first external electronic device 120 and/or the second external electronic device 130 to the processor 115.

According to an embodiment, the communication circuit 111 may transmit command data received from the processor 115 to the first external electronic device 120 and/or the second external electronic device 130. For example, the command data may include information about the required charging time predicted by the processor 115. The command data may include instructions for causing the first external electronic device 120 and/or the second external electronic device 130 to output a designated alarm through a user interface (e.g., a display, a speaker).

The memory 113 may be a volatile memory or a nonvolatile memory. When the memory 113 is volatile memory, random access memory (RAM), dynamic RAM (DRAM), static RAM (SRAM), etc., may be used. When the memory 113 is nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 113 are merely examples and are not limited thereto.

The memory 113 may store various data used by at least one component (e.g., the communication circuit 111 and/or the processor 115) of the charging time prediction apparatus 110. For example, the memory 113 may store a charging time prediction model generated by the processor 115. The memory 113 may classify the charging time prediction model generated by the processor 115 according to battery model information included in an external electronic device (e.g., the first external electronic device 120) and store the same. For example, the battery model information may include model information of the first external electronic device 120 where a battery is arranged, original equipment manufacturing (OEM) information of the battery (e.g., manufacturer information of the battery), and/or manufacturing year information of the battery.

The processor 115 may execute software to control at least one another component connected to the processor 115 and may process or compute various data. According to an embodiment, the processor 115 may control at least one another component connected to the processor 115 to perform an overall operation of the charging time prediction apparatus 110. The processor 115 may include at least one processing device, such as an application specific integrated circuit (ASIC), a digital signal processor (DSP), programmable logic devices (PLD), field programmable gate arrays (FPGAs), a central processing unit (CPU), microcontrollers, or microprocessors.

According to an embodiment, the processor 115 may generate and/or train a charging time prediction model.

According to an embodiment, the processor 115 may generate the charging time prediction model by using battery information received from the first external electronic device 120 through the communication circuit 111. The processor 115 may generate the charging time prediction model and train the generated charging time prediction model by using the battery information received from the first external electronic device 120.

According to an embodiment, the processor 115 may generate the charging time prediction model corresponding to model information of the battery, included in the obtained battery information. For example, the model information of the battery may include model information of the first external electronic device 120 where a battery is arranged, OEM information of the battery (e.g., manufacturer information of the battery), and/or manufacturing year information of the battery. According to an embodiment, the processor 115 may train the generated charging time prediction model by using the battery information including the same model information.

According to an embodiment, the processor 115 may obtain first battery information from the first external electronic device 120 through the communication circuit 111. For example, the first battery information may include current value, temperature value, SoC, and SoH of the battery included in the first external electronic device 120. According to an embodiment, the first battery information may be obtained in real time or periodically.

According to an embodiment, the processor 115 may receive information about a driving speed of the first external electronic device 120 and/or information about whether the first external electronic device 120 is connected to an external charger from the first external electronic device 120 through the communication circuit 111. According to an embodiment, the information about the driving speed and/or the information about connection may be obtained in real time or periodically.

According to an embodiment, the processor 115 may analyze data for a designated time period. According to an embodiment, the processor 115 may extract a charging period by analyzing data for a designated time period (e.g., first battery information, the information about the driving speed, and/or the information about connection measured for the designated time period). Hereinbelow, a description will be made of a method of extracting the charging period from the designated time period. In an embodiment, the designated time period may be a time window (e.g., one week, one day, one hour, three hours) for the processor 115 to analyze the battery information.

According to an embodiment, the processor 115 may extract a charging period based on the first battery information, the information about the driving speed of the first external electronic device 120, and/or the information about whether the first external electronic device 120 is connected to the external charger for the designated time period.

According to an embodiment, the processor 115 may extract the charging period based on a current value of the battery, included in the first battery information. According to an embodiment, the processor 115 may extract the charging period based on a period in which a current value of the battery is greater than or equal to a designated current value, on the first battery information. According to an embodiment, the processor 115 may extract, as the charging period, at least a part of the period in which the current value of the battery is greater than or equal to the designated current value, based on the first battery information. Herein, the designated current value may be 0 A. When the current value of the battery exceeds 0 A, it may mean that the battery is charged, and when the current value of the battery is less than 0 A, it may mean that the battery is discharged.

According to an embodiment, the processor 115 may extract a charging period based on the information about the driving speed of the first external electronic device 120, and the information about whether the first external electronic device 120 is connected to the external charger. According to an embodiment, the processor 115 may extract a charging period based on a period in which the driving speed of the first external electronic device 120 is a designated speed and the first external electronic device 120 is connected to the external charger. According to an embodiment, the processor 115 may extract, as the charging period, at least a part of the period in which the driving speed of the first external electronic device 120 is the designated speed and the first external electronic device 120 is connected to the external charger. Herein, the designated speed may be 0 km/hr.

According to an embodiment, the processor 115 may extract the charging period by excluding a data disconnection period, a period in which the charging time is less than a designated time, and a period in which a charging amount is less than a designated charging amount, from the designated time period based on the first battery information.

According to an embodiment, the processor 115 may extract the charging period by excluding a period in which a current change value of the battery is greater than or equal to a designated change value. When the current change value of the battery is greater than or equal to the designated change value during battery charge, it may mean that noise occurs in measured current.

According to an embodiment, the processor 115 may extract, from the designated time period, a first period in which the current value of the battery is greater than or equal to the designated current value. The processor 115 may extract, from the first period, a second period in which the driving speed of the external electronic device is the designated speed and the external electronic device is connected to the external charger. The processor 115 may extract a third period by excluding a data disconnection period, a period in which the charging time is less than a designated time, and a period in which a charging amount is less than a designated charging amount, from the second period.

According to an embodiment, the second period may include the data disconnection period. For example, a fourth period between the third period and the fourth period, included in the second period, may include the data disconnection period. When the remaining period excluding the data disconnection period from the fourth period is a period of less than a designated time, the processor 115 may extract, as the charging period, the third period excluding the fourth period. Herein, the data disconnection period may mean a period in which data is not obtained for a specific time or more from the first external electronic device 120.

According to an embodiment, the processor 115 may extract the charging period by excluding a period in which a charging amount of the battery is less than a designated charging amount, based on an SoC change amount. For example, when an SoC change amount of the fourth period between the third period and the fourth period, included in the second period, is less than a designated change amount, the processor 115 may extract, as the charging period, the third period by excluding the fourth period.

According to an embodiment, the processor 115 may extract the charging period by excluding, from the third period, a period in which a current change value of the battery is greater than or equal to a designated change value.

According to an embodiment, the processor 115 may generate and/or train the charging time prediction model by using the current value, the temperature value, the SoC, and the SoH of the battery for the extracted charging period. Hereinbelow, a description will be made of a method, performed by the processor 115, of generating and/or training the charging time prediction model. In an embodiment, the charging time prediction model may be a machine-learning model for obtaining the required charging time as output data by using, as input data, the current value, the temperature value, the SoC, the SoH, and the target SoC of the battery at a charge start time.

According to an embodiment, the processor 115 may identify the current value, the temperature value, the SoC, and the SoH of the battery for the charging period extracted from the designated time period. According to an embodiment, the processor 115 may identify the current value, the temperature value, the SoC, and the SoH of the battery at each of at least two points in time of the charging period.

According to an embodiment, the processor 115 may train the charging time prediction model based on the current value, the temperature value, the SoC, and the SoH at a first time point and the SoC at a second time point. For example, the processor 115 may train the charging time prediction model by using the current value, the temperature value, the SoC, and the SoH at the first time point and the SoC at the second time point as the input data of the charging time prediction model.

In an embodiment, the processor 115 may adjust parameters (or weight values) of a hidden layer of the charging time prediction model, on the basis of output data of the charging time prediction model based on the current value, the temperature value, the SoC, and the SoH at the first time point and the SoC at the second time point and a differential value between the first time point and the second time point. In an embodiment, the processor 115 may adjust the parameters (or weight values) of the hidden layer of the charging time prediction model such that an error between the output data of the charging time prediction model and the differential value is a value within a designated error.

According to an embodiment, the processor 115 may repeatedly train the charging time prediction model by using data of the charging period. According to an embodiment, the processor 115 may repeatedly train the charging time prediction model by using the current value, the temperature value, the SoC, and/or the SoC at every time point. For example, the charging time prediction model may be trained using data at the first time point and the second time point of the charging period, and the charging time prediction model may be trained using data at a third time point and a fourth time point of the charging period.

According to an embodiment, the processor 115 may terminate training of the charging time prediction model based on the output data of the charging time prediction model. According to an embodiment, the processor 115 may terminate training of the charging time prediction model when the error between the output data of the charging time prediction model and the differential value between at least two points in time of the charging period is within the designated error.

According to an embodiment, the processor 115 may generate and/or train the charging time prediction model using a machine learning model (e.g., a gradient boosting machine (GBM) or distributed random forest (DRF)).

Hereinbelow, a description will be made of a method, performed by the processor 115, of predicting the required charging time based on the trained charging time prediction model.

According to an embodiment, the processor 115 may predict the required charging time based on the generated and/or trained charging time prediction model.

According to an embodiment, the processor 115 may obtain second battery information from the first external electronic device 120 through the communication circuit 111. For example, the second battery information may include current value, temperature value, SoC, and SoH of the battery included in the first external electronic device 120 at a designated time point.

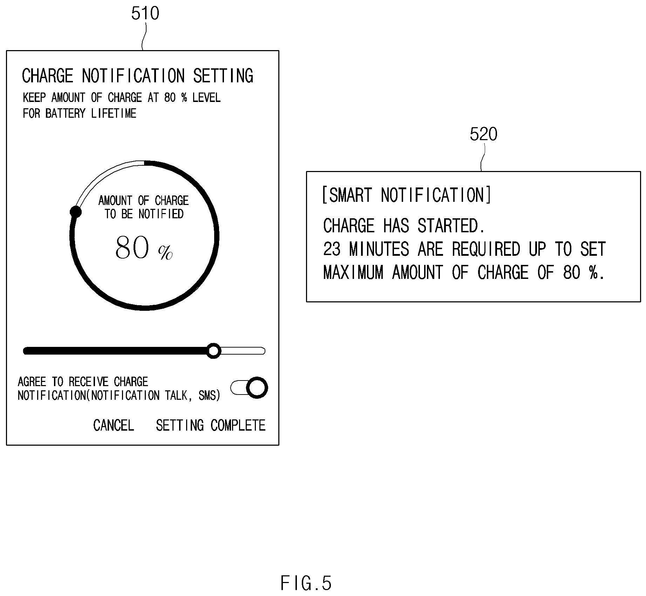

According to an embodiment, the processor 115 may predict the required charging time, included in the second battery information, to the target SoC from the SoC based on the charging time prediction model. Herein, the target SoC may mean one of SOCs between the SoC of the battery at the designated time point, included in the second battery information and the SoC at the time of full charge of the battery. According to an embodiment, the processor 115 may obtain the target SoC that is set based on a user input from the first external electronic device 120 or the second external electronic device 130. In this case, the processor 115 may output an interface (e.g., a first screen 510 of FIG. 5) through the first external electronic device 120 or the second external electronic device 130 to obtain a user input for selecting the target SoC.

According to an embodiment, the processor 115 may provide the predicted required charging time to the user. According to an embodiment, the processor 115 may transmit command data to the first external electronic device 120 and/or the second external electronic device 130 through the communication circuit 111. For example, the command data may include information about the predicted required charging time. The command data may include instructions for causing the first external electronic device 120 and/or the second external electronic device 130 to output a designated alarm (e.g., a second screen 520 of FIG. 5) through the user interface.

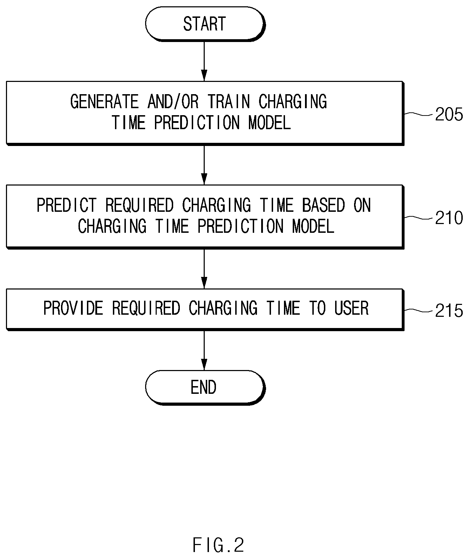

FIG. 2 is an operating flowchart of a charging time prediction apparatus according to an embodiment disclosed herein. FIG. 2 will be described using components of FIG. 1.

The embodiment shown in FIG. 2 may be an example, and an order of operations according to various embodiments of the present disclosure may be different from that shown in FIG. 2, and some operations shown in FIG. 2 may be omitted, the order of the operations may be changed, or the operations may be merged.

According to an embodiment, operations 205 to 215 may be understood as being performed by the processor 115 of the charging time prediction apparatus 110.

Referring to FIG. 2, in operation 205, the charging time prediction apparatus 110 may generate and/or train the charging time prediction model.

According to an embodiment, the charging time prediction apparatus 110 may generate the charging time prediction model by using battery information obtained from the first external electronic device 120. The charging time prediction apparatus 110 may generate the charging time prediction model and train the generated charging time prediction model by using the battery information obtained from the first external electronic device 120.

According to an embodiment, the charging time prediction apparatus 110 may generate the charging time prediction model corresponding to the model information of the battery, included in the obtained battery information. For example, the model information of the battery may include model information of the first external electronic device 120 where a battery is arranged, OEM information of the battery (e.g., manufacturer information of the battery), and/or manufacturing year information of the battery. According to an embodiment, the charging time prediction apparatus 110 may train the generated charging time prediction model by using the battery information including the same model information.

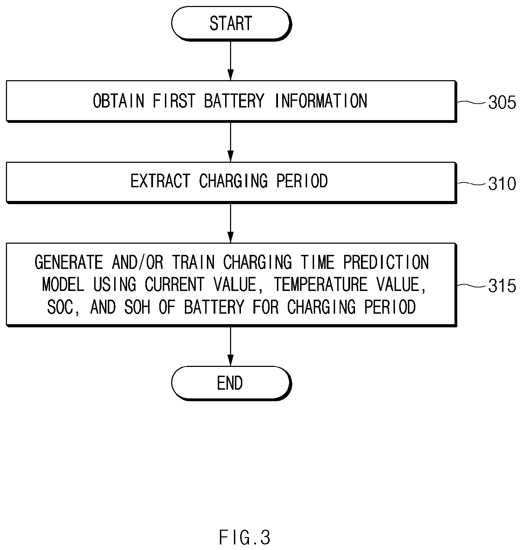

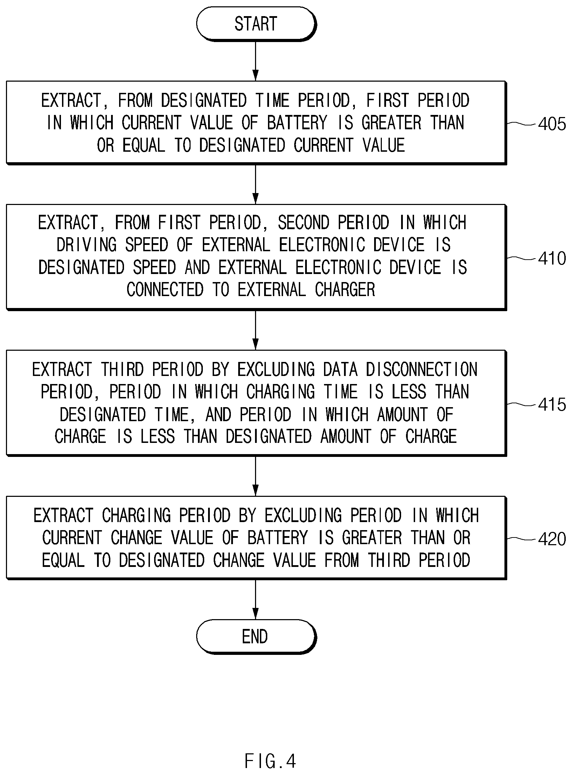

An operation, performed by the charging time prediction apparatus 110, of generating and/or training the charging time prediction model will be described in detail with reference to FIGS. 3 and 4 described below.

In operation 210, the charging time prediction apparatus 110 may predict the required charging time based on the charging time prediction model generated and/or trained in operation 205.

According to an embodiment, the charging time prediction apparatus 110 may obtain second battery information from the first external electronic device 120. For example, the second battery information may include current value, temperature value, SoC, and SoH of the battery included in the first external electronic device 120 at a designated time point.

According to an embodiment, the charging time prediction apparatus 110 may predict the required charging time, included in the second battery information, to the target SoC from the SoC based on the charging time prediction model. Herein, the target SoC may mean one of the SoC of the battery at the designated time point, included in the second battery information, and the SoC at the time of full charge of the battery. According to an embodiment, the charging time prediction apparatus 110 may obtain the target SoC that is set based on a user input from the first external electronic device 120 or the second external electronic device 130. In this case, the charging time prediction apparatus 110 may output an interface (e.g., the first screen 510 of FIG. 5) through the first external electronic device 120 or the second external electronic device 130 to obtain a user input for selecting the target SoC.

In operation 215, the charging time prediction apparatus 110 may provide the required charging time predicted in operation 210 to the user. According to an embodiment, the charging time prediction apparatus 110 may transmit command data received from the processor 110 to the first external electronic device 120 and/or the second external electronic device 130. For example, the command data may include information about the required charging time predicted in operation 210. The command data may include instructions for causing the first external electronic device 120 and/or the second external electronic device 130 to output a designated alarm (e.g., a second screen 520 of FIG. 5) through the user interface.

FIG. 3 is an operating flowchart of a charging time prediction apparatus according to an embodiment disclosed herein. FIG. 3 will be described using components of FIG. 1.

The embodiment shown in FIG. 3 may be an example, and an order of operations according to various embodiments of the present disclosure may be different from that shown in FIG. 3, and some operations shown in FIG. 3 may be omitted, the order of the operations may be changed, or the operations may be merged.

According to an embodiment, operations 305 to 315 may be understood as being performed by the processor 115 of the charging time prediction apparatus 110.

Referring to FIG. 3, in operation 305, the charging time prediction apparatus 110 may obtain the first battery information from the first external electronic device 120. For example, the first battery information may include current value, temperature value, SoC, and SoH of the battery included in the first external electronic device 120. According to an embodiment, the first battery information may be obtained in real time or periodically.

According to an embodiment, the charging time prediction apparatus 110 may analyze data for a designated time period. According to an embodiment, the charging time prediction apparatus 110 may extract a charging period by analyzing data for a designated time period (e.g., first battery information measured for the designated time period, the information about the driving speed, and/or the information about connection). Hereinbelow, a description will be made of a method, performed by the charging time prediction apparatus 110, of extracting the charging period from the designated time period. In an embodiment, the designated time period may be a time window (e.g., one week, one day, one hour, three hours) for the charging time prediction apparatus 110 to analyze the battery information.

In operation 310, the charging time prediction apparatus 110 may extract the charging time from the designated time period. According to an embodiment, the charging time prediction apparatus 110 may obtain information about a driving speed of the first external electronic device 120 and/or information about whether the first external electronic device 120 is connected to an external charger from the first external electronic device 120 through the communication circuit 110. According to an embodiment, the information about the driving speed and/or the information about connection may be obtained in real time or periodically. According to an embodiment, the charging time prediction apparatus 110 may extract a charging period based on the first battery information for the designated time period, the information about the driving speed of the first external electronic device 120, and/or the information about whether the first external electronic device 120 is connected to the external charger.

According to an embodiment, the charging time prediction apparatus 110 may extract the charging period based on a current value of the battery, included in the first battery information. According to an embodiment, the charging time prediction apparatus 110 may extract the charging period based on a period in which a current value of the battery is greater than or equal to a designated current value, on the basis of the first battery information.

According to an embodiment, the charging time prediction apparatus 110 may extract a charging period based on the information about the driving speed of the first external electronic device 120, and the information about whether the first external electronic device 120 is connected to the external charger. According to an embodiment, the charging time prediction apparatus 110 may extract a charging period based on a period in which the driving speed of the first external electronic device 120 is a designated speed and the first external electronic device 120 is connected to the external charger.

According to an embodiment, the charging time prediction apparatus 110 may extract the charging period by excluding a data disconnection period, a period in which the charging time is less than a designated time, and a period in which a charging amount is less than a designated charging amount, from the designated time period based on the first battery information.

According to an embodiment, the charging time prediction apparatus 110 may extract the charging period by excluding a period in which a current change value of the battery is greater than or equal to a designated change value. When the current change value of the battery is greater than or equal to the designated change value during battery charge, it may mean that noise occurs in measured current.

An operation, performed by the charging time prediction apparatus 110, of extracting the charging period will be described in detail with reference to FIG. 4 described below.

In operation 315, the charging time prediction apparatus 110 may generate and/or train the charging time prediction model by using the current value, the temperature value, the SoC, and the SoH of the battery for the charging period extracted in operation 310. In an embodiment, the charging time prediction model may be a machine-learning model for obtaining the required charging time as output data by using, as input data, the current time, the temperature value, the SoC, the SoH, and the target SoC of the battery at a charge start time.

According to an embodiment, the charging time prediction apparatus 110 may identify the current value, the temperature value, the SoC, and the SoH of the battery for the charging period extracted from the designated time period. According to an embodiment, the charging time prediction apparatus 110 may identify the current value, the temperature value, the SoC, and the SoH of the battery at each of at least two points in time of the charging period.

According to an embodiment, the charging time prediction apparatus 110 may train the charging time prediction model based on the current value, the temperature value, the SoC, and the SoH at a first time point and the SoC at a second time point. For example, the charging time prediction apparatus 110 may train the charging time prediction model by using the current value, the temperature value, the SoC, and the SoH at the first time point and the SoC at the second time point as the input data of the charging time prediction model.

In an embodiment, the charging time prediction apparatus 110 may adjust parameters (or weight values) of a hidden layer of the charging time prediction model on the basis of output data of the charging time prediction model based on the current value, the temperature value, the SoC, and the SoH at the first time point and the SoC at the second time point and a differential value between the first time point and the second time point. In an embodiment, the charging time prediction apparatus 110 may adjust the parameters (or weight values) of the hidden layer of the charging time prediction model such that an error between the output data of the charging time prediction model and the differential value is a value within a designated error.

According to an embodiment, the charging time prediction apparatus 110 may repeatedly train the charging time prediction model by using data of the charging period. According to an embodiment, the charging time prediction apparatus 110 may repeatedly train the charging time prediction model by using the current value, the temperature value, the SoC, and/or the SoC at every time point. For example, the charging time prediction model may be trained using data at the first time point and the second time point of the charging period, and the charging time prediction model may be trained using data at a third time point and a fourth time point of the charging period.

According to an embodiment, the charging time prediction apparatus 110 may terminate training of the charging time prediction model based on the output data of the charging time prediction model. According to an embodiment, the charging time prediction apparatus 110 may terminate training of the charging time prediction model when the error between the output data of the charging time prediction model and the differential value between at least two points in time of the charging period is within the designated error.

According to an embodiment, the charging time prediction apparatus 110 may generate and/or train the charging time prediction model by using a machine learning model (e.g., a GBM or DRF).

FIG. 4 is an operating flowchart of a charging time prediction apparatus according to an embodiment disclosed herein. FIG. 4 will be described using components of FIG. 1. FIG. 4 may be understood as a drawing that embodies operation 310 of FIG. 3.

The embodiment shown in FIG. 4 may be an example, and an order of operations according to various embodiments of the present disclosure may be different from that shown in FIG. 4, and some operations shown in FIG. 4 may be omitted, the order of the operations may be changed, or the operations may be merged.

According to an embodiment, operations 405 to 415 may be understood as being performed by the processor 115 of the charging time prediction apparatus 110.

Referring to FIG. 4, in operation 405, the charging time prediction apparatus 110 may extract, from the designated time period, the first period in which the current value of the battery is greater than or equal to the designated current value. Herein, the designated current value may be 0 A. When the current value of the battery exceeds 0 A, it may mean that the battery is charged, and when the current value of the battery is less than 0 A, it may mean that the battery is discharged.

In operation 410, the charging time prediction apparatus 110 may extract, from the first period extracted in operation 405, the second period in which the driving speed of the external electronic device is the designated speed and the external electronic device is connected to the external charger. Herein, the designated speed may be 0 km/hr.

In operation 415, the charging time prediction apparatus 110 may extract a third period by excluding a data disconnection period, a period in which the charging time is less than a designated time, and a period in which a charging amount is less than a designated charging amount, from the second period extracted in operation 410.

According to an embodiment, the second period extracted in operation 410 may include the data disconnection period. For example, a fourth period between the third period and the fourth period, included in the second period, may include the data disconnection period. When the remaining period excluding the data disconnection period from the fourth period is a period of less than a designated time, the charging time prediction apparatus 110 may extract, as the charging period, the third period excluding the fourth period. Herein, the data disconnection period may mean a period in which data is not obtained for a specific time or more from the first external electronic device 120.

According to an embodiment, the charging time prediction apparatus 110 may extract the charging period by excluding a period in which a charging amount of the battery is less than a designated charging amount, based on an SoC change amount. For example, when an SoC change amount of the fourth period between the third period and the fourth period, included in the second period, is less than a designated change amount, the charging time prediction apparatus 110 may extract, as the charging period, the third period by excluding the fourth period.

According to an embodiment, in operation 420, the charging time prediction apparatus 110 may extract the charging period by excluding, from the third period extracted in operation 415, a period in which a current change value of the battery is greater than or equal to a designated change value. When the current change value of the battery is greater than or equal to the designated change value during battery charge, it may mean that noise occurs in measured current.

FIG. 5 is a view showing an interface provided by a charging time prediction apparatus to a user, according to an embodiment disclosed herein. FIG. 5 will be described using components of FIG. 1.

The charging time prediction apparatus 110 may display the first screen 510 and/or the second screen 520 of FIG. 5 through a display of the first external electronic device 120 and/or a display of the second external electronic device 130.

According to an embodiment, the charging time prediction apparatus 110 may output the first screen 510 through the display of the first external electronic device 120 or the display of the second external electronic device 130 to obtain a user input for selecting the target SoC. The first screen 510 may include an interface for inducing the user to select whether to receive the target SoC and/or a required charging time notification through a touch input. The charging time prediction apparatus 110 may determine whether to send the target SoC and/or the required charging time notification based on the user input inputted through the display displaying the first screen 510.

According to an embodiment, the charging time prediction apparatus 110 may output the second screen 520 through the display of the first external electronic device 120 or the display of the second external electronic device 130 to provide the predicted required charging time to the user. According to an embodiment, when the user selects to receive the required charging time notification through the display displaying the first screen 510, the charging time prediction apparatus 110 may output the second screen 520 at the time when battery charge of the first external electronic device 120 starts. The second screen 520 may include information about whether the battery charge of the first external electronic device 120 started, the target SoC, and the predicted required charging time.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A charging time prediction apparatus comprising:
a communication circuit; and
a processor,
the processor is configured to:
receive, from an external electronic device and through the communication circuit, first battery information comprising a current value, a temperature value, a state of charge (SoC), and a state of health (SoH) during a designated time period of a battery included in the external electronic device;
receive, through the communication circuit, information about a driving speed of the external electronic device and/or information about whether the external electronic device is connected to an external charger for the designated time period;
extract a charging period from the designated time period based on the first battery information, the information about the driving speed, and/or the information about the connection for the designated time period; and
generate a charging time prediction model by using a current value, a temperature value, an SoC, and an SoH at a first time point of the charging period and an SoC at a second time point of the charging period.

2. The charging time prediction apparatus of claim 1, wherein the processor is further configured to generate the charging time prediction model based on a machine learning model.

3. The charging time prediction apparatus of claim 1, wherein the processor is further configured to:
receive, from the external electronic device and through the communication circuit, second battery information including a current value, a temperature value, an SoC, and an SoH of the battery at a designated time point; and
predict a required charging time from the SoC to a target SoC at the designated time point based on the charging time prediction model.

4. The charging time prediction apparatus of claim 1,
wherein the first battery information comprises model information of the battery; and
wherein the processor is further configured to generate the charging time prediction model corresponding to the model information.

5. The charging time prediction apparatus of claim 1, wherein the processor is further configured to extract, as the charging period and from the designated time period, at least a part of a first period in which the current value of the battery is greater than or equal to a designated current value.

6. The charging time prediction apparatus of claim 5, wherein the processor is further configured to extract, as the charging period and from the first period, at least a part of a second period in which the driving speed of the external electronic device is a designated speed and the external electronic device is connected to the external charger.

7. The charging time prediction apparatus of claim 6, wherein the processor is further configured to extract, as the charging period and from the second period, at least a part of a third period by excluding a data disconnection period, a period in which a charging time is less than a designated time, and a period in which a charging amount is less than a designated charging amount.

8. The charging time prediction apparatus of claim 7, wherein the processor is further configured to extract, as the charging period and from the third period, a period by excluding a period in which a current change value of the battery is greater than or equal to a designated change value.

9. The charging time prediction apparatus of claim 1, wherein the processor is further configured to transmit a required charging time to the external electronic device through the communication circuit to provide a predicted required charging time to a user.

10. A charging time prediction method comprising:
obtaining first battery information comprising a current value, a temperature value, a state of charge (SoC), and a state of health (SoH) of a battery included in an external electronic device for a designated time period;
obtaining information about a driving speed of the external electronic device and/or information about whether the external electronic device is connected to an external charger;
extracting a charging period from the designated time period based on the first battery information, the information about the driving speed, and/or the information about the connection for the designated time period; and
generating a charging time prediction model by using a current value, a temperature value, an SoC, and a SoH at a first time point of the charging period and an SoC at a second time point of the charging period.

11. The method of claim 10, wherein the first battery information comprises model information of the battery; and
wherein generating the charging time prediction model comprises generating the charging time prediction model corresponding to the model information.

12. The method of claim 10, wherein extracting the charging period comprises extracting, as the charging period and from the designated time period, at least a part of a first period in which the current value of the battery is greater than or equal to a designated current value.

13. The method of claim 12, wherein extracting the charging period comprises extracting, as the charging period and from the first period, at least a part of a second period in which a driving speed of the external electronic device is a designated speed and the external electronic device is connected to the external charger.

14. The method of claim 13, wherein extracting the charging period comprises extracting, as the charging period and from the second period, at least a part of a third period by excluding a data disconnection period, a period in which a charging time is less than a designated time, and a period in which a charging amount is less than a designated charging amount.

15. The method of claim 14, wherein extracting the charging period comprises extracting, as the charging period and from the third period, a period by excluding a period in which a current change value of the battery is greater than or equal to a designated change value.
